Europäisches Patentamt

European Patent Office

Office européen des brevets

(11) Publication number: 0 375 323
A1

## EUROPEAN PATENT APPLICATION

(21) Application number: 89313207.6

(22) Date of filing: 18.12.89

(51) Int. Cl.⁵ H01L 29/73, H01L 27/08, H01L 21/82

(30) Priority: 22.12.88 US 288518

(43) Date of publication of application:
27.06.90 Bulletin 90/26

(84) Designated Contracting States:
DE FR GB IT NL

(71) Applicant: TEXAS INSTRUMENTS
INCORPORATED
13500 North Central Expressway
Dallas Texas 75265(US)

(72) Inventor: Brighton, Jeffrey E.
4930 Sugar Grove Apt. No. 2806
Stafford Texas 77477(US)
Inventor: Bass, Alan S.
333 Preston Wood Drive Apt. No. 902
Richardson Texas 75081(US)
Inventor: Hollingsworth, Deems R.
1611 Turtle Creek
Missouri City Texas 77459(US)

(74) Representative: Abbott, David John et al
Abel & Imray Northumberland House 303-306
High Holborn
London, WC1V 7LH(GB)

(54) A high-performance vertical PNP transistor compatible with an advanced ECL bipolar technology and method of manufacturing same.

(57) The disclosure relates to a high performance vertical PNP transistor compatible with an advanced ECL bipolar technology and method of manufacturing same. Features of the disclosure are a high performance PNP transistor having an emitter (31) to extrinsic base (51) spacing of less than 0.5 micron and specifically as little as 0.3 micron. This is accomplished by providing a side wall oxide (41) on a doped contacting layer (23) whereby the contacting layer dopant diffuses into the epitaxial layer to form the emitter region (31). The extrinsic base region (51) is formed by placing a further doped contacting layer (47) of the epitaxial layer partly over the side wall oxide (41) whereby the dopant from the further doped contacting layer forms the extrinsic base region in the epitaxial layer and the side wall oxide (41) operates as a spacer to provide closer spacing between extrinsic base (51) and emitter (31) than can presently be obtained by photolithographic techniques.

Fig. 8

# A HIGH-PERFORMANCE VERTICAL PNP TRANSISTOR COMPATIBLE WITH AN ADVANCED ECL BIPOLAR TECHNOLOGY AND METHOD OF MANUFACTURING SAME

## BACKGROUND OF THE INVENTION

### FIELD OF THE INVENTION

This invention relates to bipolar transistors and, more specifically, to vertical PNP transistors and the method of manufacture thereof.

### BRIEF DESCRIPTION OF THE PRIOR ART

Emitter coupled logic (ECL) circuits are widely used in the semiconductor industry for very high speed circuit applications. Such circuits will normally include a coupled transistor pair which performs the actual logic switching and an emitter follower which is connected to the coupled transistor pair and provides additional drive on that particular gate to allow high fan in and high fan out drive capability. While ECL is a very high performance logic form, ECL circuits also dissipate a relatively large amount of power, this adding stringent packaging constraints and circuit cooling problems within a system. One area where power consumption can be reduced is in the emitter follower output.

ECL gates have excellent drive capability resulting from the use of emitter follower circuits on their outputs. With a rising transition, the emitter follower transistor will actively pull up the output line, making the transition relatively insensitive to the load conditions. A falling transition, however, is controlled by a resistor pull-down. During the falling transition, it is necessary to discharge current from the emitter. To a great extent, the speed of discharge is determinative of the operating speed of the circuit since a first gate must shut off before the next gate can become fully activated. It is therefore necessary that the speed of the falling transition be maximized where speed is a consideration. One standard prior art method to speed up the rate of fall of the falling edge is to use a low-value resistor at the emitter, this resulting in very high DC power consumption since the resistor is always on. This power consumption generates heat and limits the amount of integration possible on the chip. A trade-off therefore exists between speed and power dissipation in the circuit, i.e, degree of integration.

An active pull-down circuit has been designed to speed up the falling transition using a PNP transistor with a current mirror diode in a Motorola data sheet for the MC315 line driver. Such circuits have much lower DC power dissipation and, during a falling transition, the PNP transistor provides a surge of current into the substrate which helps discharge the load capacitance more rapidly. The circuit requires a high-frequency, high current gain PNP transistor with a matched P-N diode. Typically, however it is very difficult to build a high-performance PNP transistor which is compatible with a standard bipolar technology in order to fabricate integrated circuits having both NPN and PNP transistors. While the active pull-down should theoretically improve the circuit performance, it is believed that the above described circuit was unsuccessful because such transistors could not be built of sufficiently high quality (i.e., were not of sufficiently high performance) to function well. Specifically, the PNP transistor should have high current gain and cutoff frequency comparable to the NPN transistor, this being difficult to obtain in process flows which are compatible with standard bipolar technology.

A typical method for integrating PNP transistors in an NPN bipolar technology is suitably described by Tang et al. "1.25 um Deep-Groove-Isolated Self-Aligned Bipolar Circuits", IEEE Journal of Solid State Circuits, Vol. SC-17, No. 5, pp. 925-931, Oct. 1982. This method entails building a lateral transistor using the N-type epitaxial layer for the base and diffusing two P + regions for collector and emitter. This method is commonly used by several circuit manufacturers. While the resulting PNP transistor is compatible with standard bipolar processing, it typically has very low current gain and poor frequency response. The reasoning is that the performance of such PNP transistors is determined by the distance between the emitter and collector diffusions, this being the base width of the device. The base width, however, is lithography limited which, in the present state of the art, is about 1.5 to 2 microns. Gains in such transistors are therefore usually in the 1 to 5 range and possibly up to 10 whereas gains of about 50 to 100 and even higher are required. The device is therefore not a "high performance" device and is therefore unsuitable for the proposed ECL application.

A method of building lateral high performance PNP transistors is described in Patent No. 4,583,106 of Anantha et al. This patent has the problem that it does not fit the bipolar technology well and requires several extra masking steps in view thereof and has relatively high base resistance since the epitaxial layer, which is high resistance material required for the collector, is also the base.

A method for building a high-performance vertical PNP transistor is described by Shepard, "Self-Aligned Bipolar Transistor", IBM Technical Disclosure Bulletin, Vol. 27, No. 2, pp. 1008-1009, July, 1984. This technique is completely analogous to a polysilicon self-aligned NPN technology such as Texas Instruments' ExCL (a trademark of Texas Instruments Incorporated), and while the resulting transistor undoubtedly has excellent characteristics, it is not easily integratable with NPN processing and is therefore not very useful.

## SUMMARY OF THE INVENTION

In accordance with the present invention, the above noted problems of the prior art are minimized and there is provided a vertical PNP transistor merged with a polysilicon self-aligned (PSA) type device, a vertical PNP transistor having low base resistance, a high performance vertical PNP as well as the method of making same. There is provided a method for building a vertical PNP transistor using the substrate for the collector by adding only minimal processing steps to the process flow as described in Serial No. 932,752, filed November 19, 1986 (TI-11679A), now allowed. While ExCLTM is the technology discussed herein, it should be understood that the techniques are applicable to other advanced bipolar technologies.

Briefly, in accordance with the present invention, a PNP transistor suitable for ECL circuit applications and integratable with EXCLTM or other advanced bipolar technologies is provided. The device cross-section looks very similar to an NPN ExCLTM transistor. The differences are that the N+ buried layer has been omitted and a P+ buried layer is used as an option, the diffused P+ region which forms the extrinsic base of the NPN transistor is used to form the emitter of the PNP device, and the P intrinsic base has been omitted so that the same N+ polysilicon which serves as the emitter for the NPN transistor is used for a self-aligned base contact. The self-aligned base contacting layer provides excellent packing density potential and minimizes base resistance, thus enhancing the transistor performance. The base width is defined by the spacing between the P+ junction and the substrate or P+ buried layer and is therefore controllable to a width on the order of less than 0.5 micron. The resulting transistor has high current gain and frequency response comparable to some of the mature NPN technologies. The current mirror diode is built simply by adding the N+ buried layer for isolation, and the collector contact is omitted.

The device described may be built with minimal additional processing. For the baseline ExCLTM process flow, the N+ buried layer which was implanted into the entire wafer must be patterned with photoresist so that an epitaxial layer may be deposited directly on top of the P- substrate. If a P+ buried layer is required (the buried layer may be needed for programmable devices with a thicker epitaxial layer), the N+ implant is blocked with a nitride mask which inhibits oxide growth in the masked regions during the N+ buried layer diffusion. Then the P+ buried layer may be implanted without a second photoresist pattern. The only additional process step required is a deep P+ implant prior to the P+ polysilicon deposition to form the PNP collector (substrate) contact. The remaining process steps are completely compatible with the ExCLTM process flow.

Vertical substrate PNP transistors have been built as described above with ExCLTM test material, and transistor Hfe of >150 has been measured. Using this technique, emitter follower circuits with active pull-down are feasible.

## BRIEF DESCRIPTION OF THE DRAWINGS

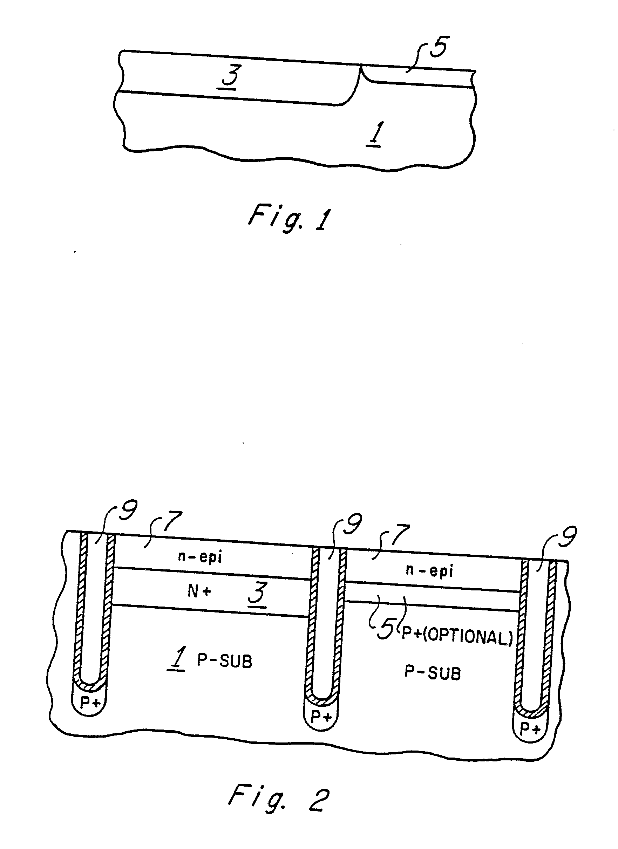

FIGURES 1 through 8 are schematic diagrams depicting the device during different stages of the process flow, FIGURE 8 showing the completed device.

## DESCRIPTION OF THE PREFERRED EMBODIMENTS

Referring now to the drawings, there is shown the structural arrangement at various stages of the process flow as will be described hereinbelow wherein both a PNP and an NPN transistor will be formed together on a single substrate. It will be understood that the processing techniques herein can be used, where appropriate, to form only PNP or only NPN devices.

Referring first to FIGURE 1, there is shown a P-type substrate 1 onto which has been patterned and implanted an N+ buried layer 3 and then, optionally, a P+ type buried layer 5. The PNP device will be built in the region of the optional P+ buried layer 5 and the NPN device will be built in the region of the N+ implant 3. The necessity of formation of the buried layer 5 is determined by the thickness of the epitaxial layer 7 (FIGURE 2) to be formed thereover, this being product related. The requirement of the layer 5 is determined by the base width obtained without this layer. If the base width is otherwise too great, then the buried layer 5 will be used. The buried layer 5 will be omitted from the remainder of the discussion, it being understood that, with the existence thereof, there will be some diffusion of the P-type impurity into the epitaxial layer 7 formed thereabove to provide a smaller width dimension of the base (distance from emitter to substrate) than would be present if the buried layer 5 were omitted.

Referring now to FIGURE 2, an N-type epitaxial layer 7 is grown over the substrate and isolation trenches 9 are then formed to isolate the NPN and PNP devices. The trenches are formed by appropriate standard patterned masking to expose the regions where the trenches are to be formed with etching of the epitaxial layer 7 and a portion of the substrate 1 through the unmasked regions in standard manner.

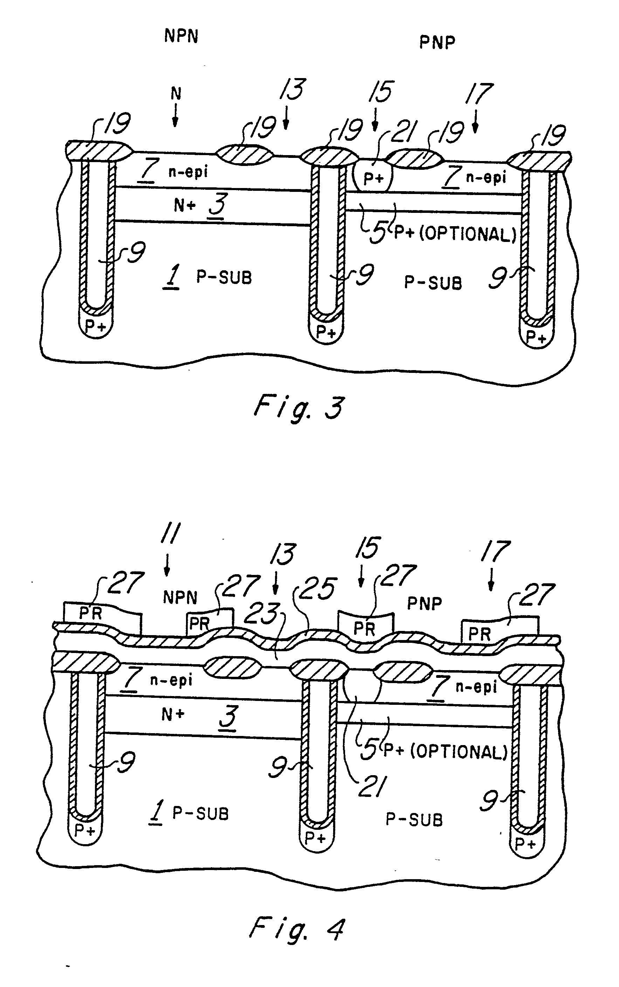

Referring now to FIGURE 3, moat regions 11, 13, 15 and 17, separated by field oxide 19 are formed by conventional selective oxidation techniques. Moat regions 11, 13, 15 and 17 define areas for the subsequent formation of the NPN base and emitter, NPN collector diffusion, PNP collector diffusion (substrate contact) and PNP base and emitter diffusions, respectively. While a top side substrate contact formed in moat region 15 is described herein, it should be understood that the steps for producing this contact can be omitted with the PNP collector contact being made to the bottom or back portion of the substrate 1. Using conventional photolithographic processing techniques, a photoresist mask is formed with an opening over PNP collector moat region 15 and P + sinker region 21 is formed by boron ion implantation. After removing the photoresist, the boron is diffused such that P + sinker 21 extends completely through the epitaxial layer 7 and contacts the substrate 1. Typically, a boron ion dose of 3 to $7 \times 10^{14}/cm^2$ implanted at 180 KeV followed by an anneal for 15 to 30 minutes at 1000°C. is sufficient to form the P + sinker 21.

Referring now to FIGURE 4, a layer of P + (boron doped) polycrystalline silicon 23 (polysilicon) is conformally deposited over the entire substrate followed by a conformally deposited layer of silicon dioxide 25. A patterned photoresist 27 is then formed over the silicon dioxide layer 25 which partially overlaps into NPN emitter/base moat region 11, leaving an opening in the center of moat 11, which completely covers PNP sinker moat region 15 and partially overlaps at least one side of PNP emitter/base moat region 17.

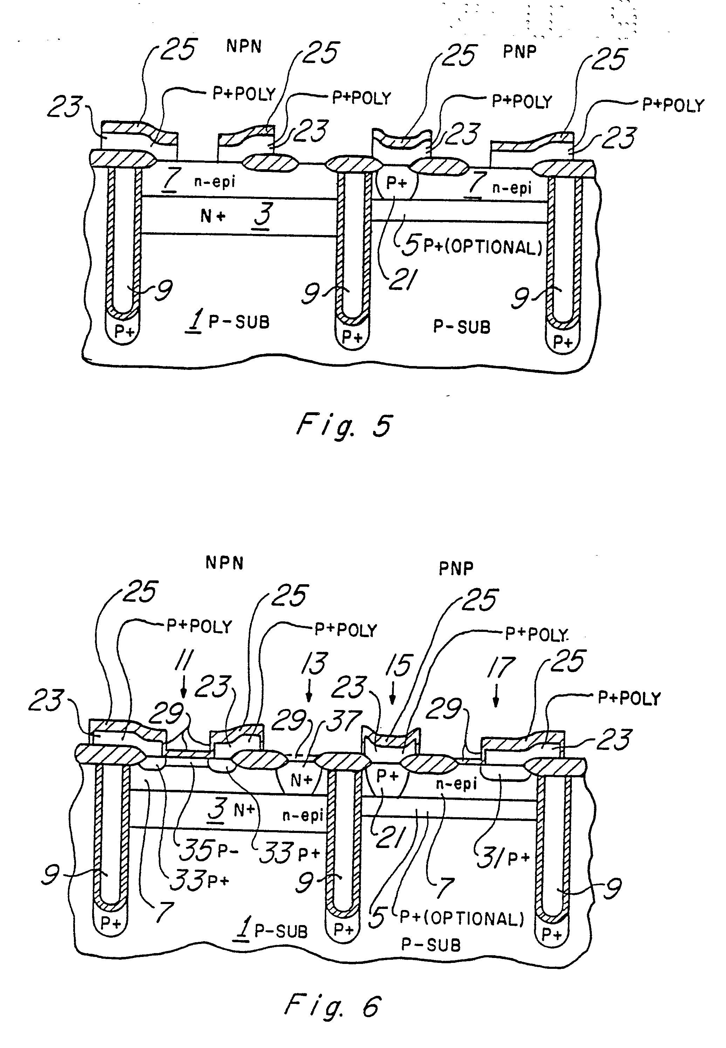

Referring now to FIGURE 5, the portions of the oxide layer 25 not covered by photoresist 27 and the polysilicon layer portion 23 thereunder are etched away and photoresist 27 is removed.

Referring now to FIGURE 6, the substrate is annealed by thermally growing thin oxide in the exposed silicon regions thereof whereby the P + dopant diffuses from the polysilicon layer 23 into the epitaxial layer 7 therebelow to form an emitter region 31 of the PNP transistor and P + extrinsic base regions 33 of the NPN transistor. A photoresist mask (not shown) is formed with an opening over NPN emitter/base moat 11 through which boron is ion implanted to form intrinsic base region 35. The photoresist mask is removed and another photoresist mask (not shown) is formed with an opening over NPN collector moat region 13. Oxide layer 29 (shown in phantom) in moat region 13 is etched away and phosphorus is ion implanted through the opening in the photoresist mask to form the deep N + sinker region 37. The photoresist is subsequently removed.

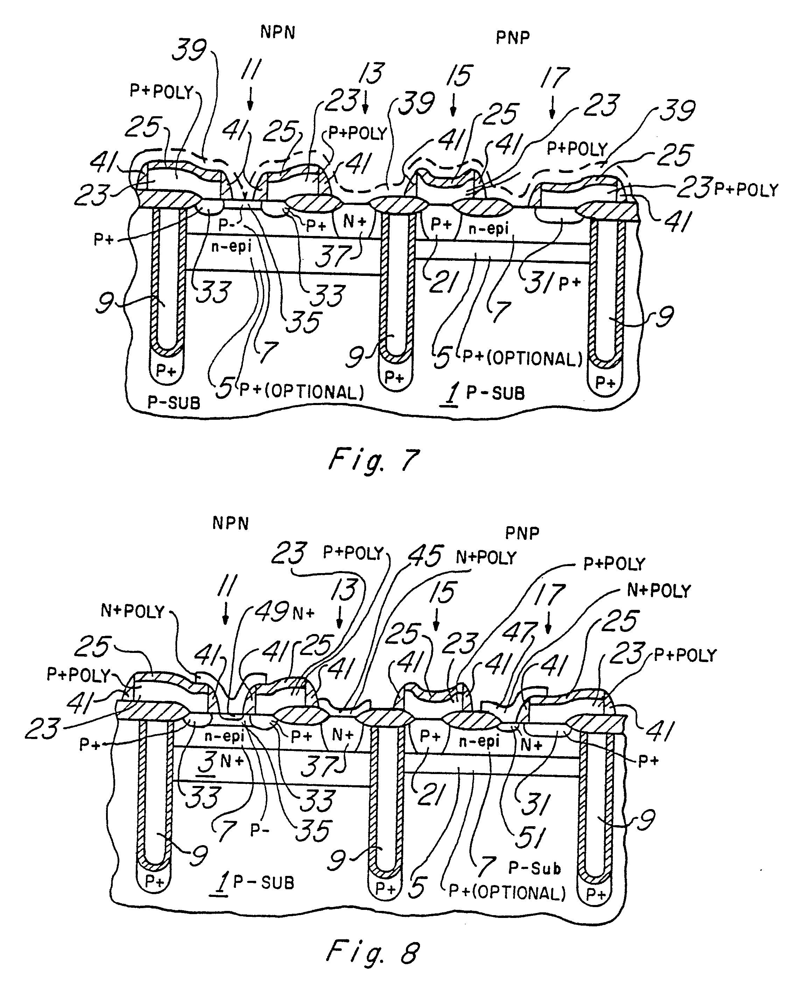

Referring now to FIGURE 7, a dielectric layer 39 (shown in phantom) is deposited and removed using an anisotropic etch, leaving sidewall plugs 41 on the vertical sidewalls of the stacks formed by P + polysilicon layer 23 and oxide layer 25. The etchback process removes the entire thickness of layer 39 plus the thickness of oxide layer 29, thus exposing the surface of the silicon in portions of moat regions 11, 13 and 17.

Referring now to FIGURE 8, N + polysilicon layers 43, 45 and 47 are formed by depositing polysilicon, doping it with an n-type impurity (arsenic or phosphorus), patterning a photoresist mask (not shown), etching the exposed portions of the polysilicon and removing the photoresist. The substrate is then annealed at 900 to 1000°C. for a time sufficient to diffuse N-type dopant from the polysilicon layers 43 and 47 to form NPN emitter region 49 and PNP N + extrinsic base region 51 respectively.

As shown in FIGURE 8, self-aligned PNP and NPN transistors have been simultaneously fabricated. The PNP collector sinker 21 and emitter 31 regions are contacted by P + polysilicon layer 23 and the emitter 31 was formed by diffusion of boron from the P + polysilicon 23. The PNP emitter area is defined by the intersection of moat region 17 and P + polysilicon 23. The PNP base is contacted by N + polysilicon 47 through N + extrinsic base region 51 and the N + extrinsic base 51 was formed by diffusing an N-type dopant from N + polysilicon 47. The separation between the PNP emitter 31 and the N + extrinsic base 51 is defined by the width of the self-aligning sidewall plug 41 that was formed on the vertical sidewall of the P + polysilicon 23 and oxide layer 25. Correspondingly, the NPN collector sinker 37 and emitter 49 are contacted by N + polysilicon layers 45 and 43 respectively and the emitter 49 was formed by diffusion of an n-type dopant from N + polysilicon 43. The NPN emitter dimensions are defined by the separation between P + polysilicon layers 23 within moat region 11 less the width of the self-aligning sidewall plugs 41. The NPN base is contacted by P + polysilicon 23 through P + extrinsic base regions 33 and the P + extrinsic base 33 was formed by diffusing boron from P + polysilicon 23.

The separation between NPN emitter 49 and P+ extrinsic base 33 is defined by the width of the self-aligning sidewall plug 41. Contacts to the P+ polysilicon layer 23 through oxide 25 are formed by known means and appropriate metallization as is well known is now provided.

It can be seen that there has been provided a method of manufacturing a vertical high performance PNP transistor merged with technology for building the NPN transistor. The PNP transistor as formed is novel and lends itself to fabrication using the same processing steps as required for simultaneous formation of NPN transistors. More specifically, a vertical PNP transistor is merged with a poly-self-aligned (PSA) device wherein the base resistance of the PNP transistor is substantially reduced by bringing the base contact very close to the emitter contact.

A vertical PNP merged with a PSA type device, a vertical PNP transistor with low $R_b$ due to the method of placing the base contact very close to the active base part of the transistor and a high performance vertical PNP transistor such that can be used effectively in an active pull down in an emitter follower in an ECL circuit have been provided as well as a method of making the device.

Though the invention has been described with respect to specific preferred embodiments thereof, many variations and modifications will immediately become apparent to those skilled in the art. It is therefore the intention that the appended claims be interpreted as broadly as possible in view of the prior art to include as such variations and modifications.

## Claims

1. A transistor comprising:

(a) a semiconductor substrate of predetermined conductivity type,

(b) a semiconductor layer on and contacting said substrate of opposite conductivity type having an exposed major surface,

(c) a charge emitting region in said layer of said predetermined conductivity type extending to said surface,

(d) a control region in said layer of opposite conductivity type adjacent said charge emitting region extending to said surface,

(e) a charge collecting region in said layer of said predetermined conductivity type defined in said substrate,

(f) a first polysilicon contacting layer of said predetermined conductivity type coupled to said charge emitting region,

(g) a second polysilicon contacting layer of said opposite conductivity type coupled to said control region and separated from said first contacting layer by an oxide spacer therebetween, and

(h) a contact to said substrate.

2. The transistor of claim 1 wherein said contact to said substrate includes a contact region of said predetermined conductivity type extending from said surface of said layer to said substrate and a third polysilicon contacting layer of predetermined conductivity type coupled to said contact region.

3. A transistor as set forth in claim 1 wherein said predetermined conductivity type is P-type.

4. A transistor as set forth in claim 2 wherein said predetermined conductivity typed is P-type.

5. A semiconductor circuit on a single semiconductor substrate, comprising:

(a) a semiconductor substrate of predetermined conductivity type,

(b) a semiconductor layer on and contacting said substrate of opposite conductivity type having an exposed major surface,

(c) a trench extending entirely through said layer and into said substrate to form plural electrically isolated regions in said layer and substrate, one of said electrically isolated regions comprising:

(d) a charge emitting region in said layer of said predetermined conductivity type extending to said surface,

(e) a control region in said layer of opposite conductivity type adjacent said charge emitting region extending to said surface,

(f) a charge collecting region in said layer of said predetermined conductivity type defined in said substrate,

(g) a first polysilicon contacting layer of said predetermined conductivity type coupled to said charge emitting region,

(h) a second polysilicon contacting layer of said opposite conductivity type coupled to said control region and separated from said first contacting layer by an oxide spacer therebetween, and

(i) a contact to said substrate, a second of said electrically isolated regions comprising:

(j) a transistor having a charge emitting region and a charge collecting region of said opposite conductivity type and a control region of said predetermined conductivity type.

6. The semiconductor circuit of claim 5 wherein said contact to said substrate includes a contact region of said predetermined conductivity type extending from said surface of said layer to said substrate and a third polysilicon contacting layer of predetermined conductivity type coupled to said contact region.

7. The semiconductor circuit of claim 5 wherein said predetermined conductivity type is P-type.

8. The semiconductor circuit of claim 6 wherein said predetermined conductivity typed is P-type.

9. A method of making a semiconductor device, comprising the steps of:

(a) providing a substrate of predetermined conductivity type,

(b) forming a semiconductor layer on said substrate of opposite conductivity type,

(c) forming a first patterned layer of predetermined conductivity type doped polysilicon over said semiconductor layer,

(d) causing dopant from said first patterned layer to diffuse into said semiconductor layer in regions thereof below said first patterned layer,

(e) forming a sidewall oxide on the side wall of said first patterned layer,

(f) forming a second patterned layer of opposite conductivity type doped polysilicon on said semiconductor layer extending over said side wall oxide, and

(g) causing dopant from said second patterned layer to diffuse into said semiconductor layer in regions thereof below said second patterned layer.

10. The method of claim 9 further including the step of forming a heavily doped region of predetermined conductivity type at the surface of said substrate prior to forming said semiconductor layer in step (b).

11. The method of claim 9, further including implanting a region of said predetermined conductivity type in said semiconductor layer extending from the surface of said layer to said substrate and electrically isolated at the surface of said semiconductor layer from said first and second patterned layers.

12. The method of claim 10, further including implanting a region of said predetermined conductivity type in said semiconductor layer extending from the surface of said layer to said substrate and electrically isolated at the surface of said semiconductor layer from said first and second patterned layers.

13. A method of making a semiconductor circuit on a single substrate, comprising the steps of:

(a) providing a substrate of predetermined conductivity type,

(b) forming a region of opposite conductivity type in a portion of the surface of said substrate;

(c) forming a semiconductor layer on said substrate of opposite conductivity type,

(d) forming isolating trenches to electrically isolate said region of opposite conductivity type from other predetermined areas of said semiconductor layer,

(e) forming a first patterned layer of predetermined conductivity type doped polysilicon over said semiconductor layer,

(f) causing dopant from said first patterned layer to diffuse into said semiconductor layer in regions thereof below said first patterned layer,

(g) forming a sidewall oxide on the side walls of said first patterned layer,

(h) forming a second patterned layer of opposite conductivity type doped polysilicon on said semiconductor layer extending over said side wall oxide,

(i) causing dopant from said second patterned layer to diffuse into said semiconductor layer in regions thereof below said second patterned layer, and

(j) forming contacts to said substrate and to said region of opposite conductivity type in said portion of the surface of said substrate.

14. The method of claim 13 further including the step of forming a heavily doped region of predetermined conductivity type at the surface of said substrate prior to forming said semiconductor layer in step (c).

15. The method of claim 13, further including implanting a region of said predetermined conductivity type in said semiconductor layer in said other predetermined region extending from the surface of said layer to said substrate and electrically isolated at the surface of said semiconductor layer from said first and second patterned layers.

16. The method of claim 14, further including implanting a region of said predetermined conductivity type in said semiconductor layer in said other predetermined region extending from the surface of said layer to said substrate and electrically isolated at the surface of said semiconductor layer from said first and second patterned layers.

17. A transistor comprising:

(a) a semiconductor substrate of predetermined conductivity type,

(b) a semiconductor layer on and contacting said substrate of opposite conductivity type having an exposed major surface,

(c) a charge emitting region in said layer of said predetermined conductivity type extending to said surface,

(d) a control region in said layer of opposite conductivity type adjacent said charge emitting region extending to said surface,

(e) a charge collecting region in said layer of said predetermined conductivity type defined in said substrate,

(f) a first contacting layer on said layer coupled to said charge emitting region,

(g) a second contacting layer on said layer coupled to said control region and separated from said first contact by a side wall oxide spacer therebetween and disposed on the side wall of said first contacting layer, and

(h) a contact to said substrate.

18. The transistor of claim 17 wherein said contact to said substrate includes a contact region of said predetermined conductivity type extending from said surface of said layer to said substrate and a third polysilicon contacting layer of predetermined conductivity type coupled to said contact region.

19. A transistor as set forth in claim 17 wherein said predetermined conductivity type is P-type.

20. A transistor as set forth in claim 18 wherein said predetermined conductivity typed is P-type.

Fig. 1

Fig. 2

NPN                                                        PNP

N          13          15          17

19          19    19   21  19          19

7  n-epi          P+          7  n-epi

N+  3

5  P+ (OPTIONAL)

9          1  P-SUB          9          P-SUB          9

P+                P+                P+

**Fig. 3**

11          13          15          17

27          27          25          27          27

PR          PR    23          PR          PR

7  n-epi          7  n-epi

N+  3

9          9          5  P+ (OPTIONAL)

21

1  P-SUB          P-SUB

P+                P+                P+

**Fig. 4**

Fig. 5

Fig. 6

Fig. 7

Fig. 8

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | EP-A-0 231 740 (TEXAS INSTRUMENTS) <br> * Figure 29 * <br> --- | 1 | H 01 L 29/73 <br> H 01 L 27/08 <br> H 01 L 21/82 |
| X | IBM TECHNICAL DISCLOSURE BULLETIN, vol. 21, no. 2, July 1978, pages 846-849; T.H. NING et al.: "Bipolar transistor structure" <br> * Figures 7-12 * | 9 | |
| Y | IDEM <br><br> --- | 1,3,10, 17,19 | |
| Y | PATENT ABSTRACTS OF JAPAN, vol. 10, no. 192 (E-417)[2248], 5th July 1986; & JP-A-61 36 944 (NEC CORP.) 21-02-1986 <br> * Whole document * <br> --- | 1,3,10, 17,19 | |
| A | PATENT ABSTRACTS OF JAPAN, vol. 10, no. 259 (E-434)[2315], 4th September 1986; & JP-A-61 85 863 (NEC CORP.) 01-05-1986 <br> * Whole document * <br> ----- | 5 | |

TECHNICAL FIELDS
SEARCHED (Int. Cl.5)

H 01 L

The present search report has been drawn up for all claims

| Place of search | Date of completion of the search | Examiner |
|---|---|---|
| THE HAGUE | 20-03-1990 | NILES N.P.E. |